(19) Europäisches Patentamt / European Patent Office / Office européen des brevets

(11) **EP 3 796 020 B1**

(12) **EUROPÄISCHE PATENTSCHRIFT**

(45) Veröffentlichungstag und Bekanntmachung des Hinweises auf die Patenterteilung:
**17.07.2024 Patentblatt 2024/29**

(21) Anmeldenummer: **19197748.7**

(22) Anmeldetag: **17.09.2019**

(51) Internationale Patentklassifikation (IPC):
**G01R 33/36** (2006.01) **G01R 33/54** (2006.01)
**G01R 33/567** (2006.01) **G01R 33/58** (2006.01)

(52) Gemeinsame Patentklassifikation (CPC):
**G01R 33/3692; G01R 33/543;** G01R 33/5673;
G01R 33/583

(54) **EMPFANG VON NUTZSIGNALEN IM MAGNETRESONANZ-FREQUENZBAND**

RECEPTION OF USEFUL SIGNALS IN THE MAGNETIC RESONANCE FREQUENCY BAND

RÉCEPTION DES SIGNAUX UTILISATEUR DANS UNE BANDE DE FRÉQUENCES DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.03.2021 Patentblatt 2021/12**

(73) Patentinhaber: **Siemens Healthineers AG**
**91301 Forchheim (DE)**

(72) Erfinder: **Biber, Stephan**
**91056 Erlangen (DE)**

(74) Vertreter: **Siemens Healthineers**
**Patent Attorneys**
**Postfach 22 16 34**
**80506 München (DE)**

(56) Entgegenhaltungen:
**US-A1- 2006 244 452 US-A1- 2013 342 199**
**US-A1- 2018 045 801**

EP 3 796 020 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Verfahren zur Ermittlung einer Auswertungsinformation aus einem durch eine Magnetresonanzvorrichtung empfangenen Empfangssignal, ein Computerprogrammprodukt zur Ausführung eines solchen Verfahrens und eine Magnetresonanzvorrichtung.

Die Magnetresonanztomographie (MRT; engl. Magnetic Resonance Imaging, MRI) ist eine bekannte Technik zum Erzeugen von Abbildungen eines Körperinneren eines Patienten, also von Magnetresonanzabbildungen. Dazu werden in einer Magnetresonanzvorrichtung typischerweise einem statischen Grundmagnetfeld schnell geschaltete Gradientenpulse überlagert, die von einem Gradientensystem der Magnetresonanzvorrichtung erzeugt werden. Ferner werden von einer Hochfrequenzsendespule (HF-Sendespule) der Magnetresonanzvorrichtung zum Auslösen von Magnetresonanzsignalen hochfrequente Magnetresonanzanregungssignale in den Patienten eingestrahlt und die ausgelösten Magnetresonanzsignale aufgenommen.

Die Druckschrift US 2006/244452 A1 beschreibt ein Verfahren, bei dem ein hochfrequentes Referenzsignal erzeugt und empfangen wird. Anhand des empfangenen Referenzsignals wird ein Magnetresonanzsignal korrigiert. Die Druckschrift US 2018/045801 A1 beschreibt ein Verfahren zu einer Erzeugung einer Bewegungsinformation zu einem Untersuchungsbereich eines Patienten. Die Druckschrift US 2013/342199 A1 offenbart ein Verfahren zum Bestimmen einer Kommunikationslatenz in einem Magnetresonanztomographen.

Neben den Magnetresonanzsignalen können Auswertungsinformationen von Nutzen sein. Solche Auswertungsinformationen sind beispielsweise Informationen, anhand derer eine Korrektur einer Bewegung des Patienten, z.B. Atmung, Herzschlag, Bewegung von Kopf, Extremitäten und Abdomen, während der Aufnahme der Magnetresonanzsignale vorgenommen werden können. Ein weiteres Bespiel für Auswertungsinformationen sind Signale, anhand derer eine Empfangskette der Magnetresonanzvorrichtung kalibriert und/oder überwacht werden kann. Dies ermöglicht beispielsweise eine höhere Stabilität während einer Messung oder eine leichtere Sucht etwaige Fehler bei einer Wartung der Magnetresonanzvorrichtung.

Als Aufgabe der vorliegenden Erfindung kann angesehen werden, auf ein effizientes Verfahren zur Ermittlung von Auswertungsinformationen bereitzustellen.

Die Aufgabe wird durch die Merkmale der unabhängigen Ansprüche gelöst. Vorteilhafte Ausgestaltungen sind in den abhängigen Ansprüchen beschrieben.

Demnach wird ein Verfahren gemäß Anspruch 1 vorgeschlagen, bei dem eine Ermittlung einer Auswertungsinformation aus einem durch eine Magnetresonanzvorrichtung empfangenen Empfangssignal erfolgt.

Dabei wird ein Nutzsignal erzeugt, das ein erstes Frequenzband aufweist. Dabei wird in einem zweiten Frequenzband ein Magnetresonanzsignal, insbesondere durch Anregung von Protonen, erzeugt.

Das erste Frequenzband liegt zumindest teilweise, insbesondere vollständig, innerhalb des zweiten Frequenzbands, d.h. das Nutzsignal und das Magnetresonanzsignal sind nicht spektral getrennt Das Nutzsignal und das Magnetresonanzsignal überlagern sich daher zu einem Empfangssignal,

Das Empfangssignal wird durch eine Empfangseinheit der Magnetresonanzvorrichtung empfangen. Aus dem Empfangssignal wird eine Auswertungsinformation ermittelt, die das Nutzsignal charakterisiert. Die Ermittlung der Auswertungsinformation kann insbesondere mit einer Auswerteeinheit erfolgen, die vorzugsweise eine Recheneinheit und/oder eine Speichereinheit umfasst. Die Recheneinheit kann beispielsweise einen oder mehrere Prozessoren umfassen.

Vorteilhafterweise ermöglicht das angegebene Verfahren die gleichzeitige Nutzung des Magnetresonanz-Frequenzbandes, also des zweiten Frequenzbandes, für den Empfang von Magnetresonanzsignalen und Nutzsignalen. Dabei ist das Nutzsignal ein vom einem Magnetresonanzsignal verschiedenes Signal, d.h. es wird nicht erzeugt mit Hilfe des physikalischen Phänomens der Magnetresonanz. Erfindungsgemäß umfasst das Empfangssignal sowohl das Magnetresonanzsignal als auch das Nutzsignal. Dadurch, dass das Nutzsignal im selben Frequenzband wie die Magnetresonanzsignale liegen, können die Nutzsignale ohne zusätzliche Vorrichtungen miterfasst werden, da die Empfangseinheit ohnehin dafür ausgelegt ist, um Magnetresonanzsignale empfangen zu können. Schwierigkeiten, die bei einer möglichen spektralen Trennung der Signale entstehen, wie z.B. notwendige zusätzliche Filter, entfallen somit.

Durch die Ermittlung der Auswertungsinformation können insbesondere die Informationen des Empfangssignals wieder getrennt werden. Insbesondere kann die das Nutzsignal charakterisierende Auswertungsinformation das Nutzsignal selbst sein. Die Auswertungsinformation kann zudem genutzt werden, um den Betrieb und/oder die Wartung der Magnetresonanzvorrichtung zu verbessern.

Unter einem Frequenzband eines Signals können insbesondere Bereiche des Frequenzspektrums des Signals, insbesondere eines Zeitsignals, verstanden werden. Beispielsweise kann ein Frequenzspektrum eines Zeitsignals durch eine FourierTransformation des Zeitsignals ermittelt werden. Ein Frequenzspektrum eines Zeitsignals eines kann beispielsweise durch den 6dB-Abfall der Fourier-Transformatierten des Zeitsignals beschrieben werden.

Das zweite Frequenzband umfasst erfindungsgemäß die Larmorfrequenz $f_{Larmor}$, d.h. die Frequenz der Larmorpräzession der Atome, bei der eine Anregung durch die Magnetresonanzanregungssignale erfolgt.

Die Larmorfrequenz $f_{Larmor}$ lässt sich berechnen mit:

$$f_{Larmor} = \frac{\gamma}{2\pi} \cdot |B|$$

Dabei ist $\gamma$ das gyromagnetische Verhältnis, das abhängig ist von dem anzuregenden Teilchen. Meistens werden bei einer Magnetresonanzuntersuchung Protonen angeregt. Hierfür gilt $\gamma_P = 2,675 \cdot 10^8 s^{-1} T^{-1}$. B ist die Stärke des Magnetfelds, das bei Magnetresonanzuntersuchungen üblicherweise zwischen 0,1-10 T, beispielsweise bei 1,5 T, 3 T oder 7 T, liegt.

Das zweite Frequenzband umfasst vorzugsweise den Frequenzbereich $f_{Larmor} \pm W$, wobei W vorzugsweise zwischen 50 bis 1000 kHz, insbesondere 250 kHz beträgt.

Eine Empfangseinheit kann beispielsweise eine oder mehrere Empfangsspulen, z.B. Lokalspulen, umfassen, an die ein oder mehrere Verstärker zur Verstärkung des Empfangssignals angeschlossen sind. Erfindungsgemäß weist die Empfangseinheit ein Empfangsfrequenzband auf, dass das erste und das zweite Frequenzband umfasst.

Erfindungsgemäß sieht das Verfahren vor, dass in dem zweiten Frequenzband ein Magnetresonanzsignal erzeugt wird, wobei das Empfangssignal eine Überlagerung des Magnetresonanzsignals mit dem Nutzsignal aufweist.

Erfindungsgemäß befinden sich das Nutzsignal und das Magnetresonanzsignal im selben zeitlichen und spektralen Bereich. Vorzugsweise überlappen das Magnetresonanzsignal und das Nutzsignal zeitlich und spektral vollständig. Es wird somit ein gleichzeitiger Empfang von Magnetresonanzsignalen und Nutzsignalen ermöglicht.

Insbesondere können aus dem Empfangssignal das Magnetresonanzsignal und/oder das Nutzsignal extrahiert werden. Vorzugsweise wird anhand der Auswertungsinformation aus dem Empfangssignal das Magnetresonanzsignal rekonstruiert. Dazu wird vorzugsweise das Empfangssignal um das Nutzsignal bereinigt.

Vorzugsweise wird zumindest aus dem rekonstruierten Magnetresonanzsignal zumindest eine Magnetresonanzabbildung berechnet. Eine solche Magnetresonanzabbildung kann beispielsweise auf einem Monitor angezeigt und/oder auf einem Datenträger gespeichert werden.

Erfindungsgemäß umfasst das Erzeugen der Magnetresonanzsignale eine Erzeugung eines Magnetresonanzanregungssignals, ein Einstrahlung des Magnetresonanzanregungssignals in einen Patienten, eine Anregung eines Atoms des Patienten durch Wechselwirkung des Magnetresonanzanregungssignals mit dem Atomkern und ein Emittieren des Magnetresonanzsignals aus Atomkernen des Patienten.

Die Erzeugung des Magnetresonanzanregungssignals kann insbesondere mit einer HF-Sendespule, z.B. einer Ganzkörperspule (engl. body coil), erfolgen.

Erfindungsgemäß umfasst das Erzeugen des Nutzsignals eine Erzeugung eines Nutzanregungssignals und eine Änderung des Nutzanregungssignals in das Nutzsignal durch Wechselwirkung mit einem Untersuchungsobjekt.

Üblicherweise wird durch die Wechselwirkung des Nutzanregungssignals mit dem Untersuchungsobjekt die Bandbreite des Signals nur wenig verändert, so dass sich auch das Nutzanregungssignal im Wesentlichen im ersten Frequenzband befindet. Vorzugsweise wird durch die Wechselwirkung des Nutzanregungssignals mit dem Untersuchungsobjekt nur die Amplitude und/oder Phase des Signals geändert, aber nicht seine Bandbreite.

Das Nutzanregungssignal kann möglicherweise auch im Wesentlichen monofrequent ausgebildet sein, so dass das erste Frequenzband durch eine Frequenzlinie beschrieben werden kann.

Vorzugsweise wird mittels eines HF-Senders das Nutzanregungssignal erzeugt. (Der HF-Sender ist vorzugsweise eine von der HF-Sendespule verschiedene Vorrichtung.) Daraufhin wird das Nutzanregungssignal durch Wechselwirkung mit dem Untersuchungsobjekt beeinflusst, so dass aus dem Nutzanregungssignal das Nutzsignal hervorgeht. Vorteilhafterweise ist dem Nutzsignal die Wechselwirkung mit dem Untersuchungsobjekt aufgeprägt, so dass sich aus dem Nutzsignal Informationen, insbesondere das Nutzsignal charakterisierende Auswertungsinformation, über das Untersuchungsobjekt ableiten lassen.

Erfindungsgemäß sieht das vorgeschlagene Verfahren vor, dass das Untersuchungsobjekt ein Patient ist. Erfindungsgemäß wird anhand der Auswertungsinformation eine Bewegung des Patienten ermittelt.

Eine weitere Variante des vorgeschlagenen Verfahrens, die nicht in den Schutzumfang der Ansprüche fällt, sieht vor, dass das Untersuchungsobjekt eine Empfangskette der Magnetresonanzvorrichtung ist, wobei anhand der Auswertungsinformation eine Eigenschaft der Empfangskette ermittelt wird. Vorzugsweise umfasst die Empfangskette die Empfangseinheit. Sie kann noch weitere Komponenten umfassen, wie z.B. Signalverstärker, Signalwandler etc.

Die Ermittlung der Eigenschaft der Empfangskette kann beispielsweise eine Kalibrierung der Empfangskette während einer Messung ermöglichen, um insbesondere die Messstabilität zu erhöhen (z.B. bei einer Drift einer Empfangselektronik wegen Temperatureffekten). Ferner kann die Ermittlung der Eigenschaft der Empfangskette eine Überwachung der Empfangskette zu Servicezwecken und/oder zur Eingrenzung der Fehlerursache in der Empfangskette ermöglichen.

Vorzugsweise wird zur Ermittlung der Auswertungsinformation das Nutzanregungssignal verwendet. Durch Verwendung des Nutzanregungssignal kann insbesondere ein Vergleich und/oder eine Korrelation mit dem Nutzsignal durchgeführt werden. Vorteilhafterweise kann dadurch die Wechselwirkung des Nutzanregungssignals mit einem Untersuchungsobjekt genauer bestimmt und die Auswertungsinformation verbessert werden.

Vorzugsweise ist das Nutzanregungssignal in Amplitude und Phase sehr genau bekannt. Dies kann beispielsweise dadurch erreicht werden, dass ein, insbesondere digitales, Ansteuerungssignal exakt bekannt ist und ein, insbesondere analoger, HF-Sender des Nutzanregungssignals, der mit dem Ansteuerungssignal angesteuert wird, sehr genau kalibriert ist. Das Ansteuerungssignal kann beispielsweise von der Auswerteeinheit erzeugt und/oder ihr zugeführt werden.

Alternativ oder zusätzlich kann ein Anteil des Nutzanregungssignal durch einen Koppler ausgekoppelt werden. Dieser Anteil des Nutzanregungssignal kann der Auswerteeinheit zugeführt werden.

Eine weitere Ausführungsform des Verfahrens sieht vor, dass die Empfangseinheit mehrere Empfangskanäle umfasst, wobei für jeden Empfangskanal ein Gewichtungsfaktor als Auswertungsinformation ermittelt wird.

Vorzugsweise werden die Gewichtungsfaktoren durch eine, insbesondere iterative, Minimierung einer Korrelation zwischen Nutzanregungssignal und Empfangssignal ermittelt. Beispielsweise wird das Nutzanregungssignal mit einem vorläufigen Gewichtungsfaktor vom Empfangssignal subtrahiert, woraus sich ein modifiziertes Empfangssignal ergibt. Eine verbleibende Korrelation zwischen dem modifizierte Empfangssignal und dem Nutzanregungssignal wird ermittelt. Vorzugsweise wird der vorläufige Gewichtungsfaktor solange optimiert, bis die verbleibende Korrelation zwischen dem modifizierte Empfangssignal und dem Nutzanregungssignal einen vorgegebenen Schwellwert unterschreitet oder idealerweise Null wird. Der sich daraus ergebende vorläufige Gewichtungsfaktor wird als Gewichtungsfaktor verwendet.

Vorzugsweise werden die Gewichtungsfaktoren durch Rekonstruktion des Magnetresonanzsignals aus dem Empfangssignal ermittelt. Insbesondere werden dabei die Gewichtungsfaktoren so bestimmt, dass das Nutzsignal in einem modifizierten Empfangssignal minimiert wird, so dass das modifizierte Empfangssignal möglichst genau dem Magnetresonanzsignal entspricht. Aus dem modifizierten Empfangssignal können somit Magnetresonanzabbildungen des Patienten berechnet werden.

Insbesondere kann die Empfangseinheit mehrere Spulenelemente, d.h. Empfangsantennen, umfassen, die jeweils einem der mehreren Empfangskanäle zugeordnet sind. Die Spulenelemente können insbesondere in einer oder mehreren Lokalspulen und/oder in fest installierten Spulen, wie z.B. einer Ganzkörperspule (engl. body coil) angeordnet sein.

Eine bevorzugte Ausführungsform des Verfahrens sieht vor, dass das Empfangssignal mehrere Empfangssignalanteile umfasst, die jeweils durch einen Empfangskanal empfangen werden, wobei zur Rekonstruktion des Magnetresonanzsignals für jeden Empfangskanal das Nutzanregungssignal vom jeweiligen Empfangssignalanteil mit dem jeweils ermittelten Gewichtungsfaktor gewichtet subtrahiert wird.

Mit anderen Worten empfängt vorzugsweise jedes Spulenelement einen Empfangssignalanteil des Empfangssignals. Vorzugsweise gibt ein Gewichtungsfaktor an, mit welcher relativen Gewichtung das Nutzanregungssignal von dem jeweiligen Empfangssignalanteil subtrahiert wird, um aus dem Empfangssignal das Magnetresonanzsignal zu rekonstruieren.

Vorzugsweise wird die Auswertungsinformation, insbesondere die Gewichtungsfaktoren, weiterverarbeitet, um damit erfindungsgemäß eine Patientenbewegung zu detektieren und zusätzlich optional eine Eigenschaft der Empfangskette zu ermitteln. Beispielsweise wird eine veränderte Kopplung zwischen Nutzanregungssignal und Spulenelement aufgrund einer Patientenbewegung sich auf den Gewichtungsfaktor, der dem Spulenelement zugeordnet ist, auswirken. Der Gewichtungsfaktor kann dabei insbesondere als komplexwertige Zahl dargestellt werden, die direkt genutzt werden kann, um eine Patientenbewegung zu beobachten.

Eine mögliche Weiterverarbeitung der Gewichtungsfaktoren umfasst z.B. eine Ermittlung einer zeitlichen Änderung des zumindest einen Gewichtungsfaktor und/oder einen Vergleich des zumindest einen Gewichtungsfaktors mit zumindest einem vorgegebenen Referenzwert und/oder einen Vergleich des zumindest einen Gewichtungsfaktors eines Empfangskanals mit zumindest einem Gewichtungsfaktors eines anderen Empfangskanals.

Ferner wird eine Magnetresonanzvorrichtung gemäß Anspruch 10 vorgeschlagen, die ausgebildet ist, ein vorab beschriebenes Verfahren zur Ermittlung einer Auswertungsinformation aus einem durch die Magnetresonanzvorrichtung empfangenen Empfangssignal durchzuführen.

Die Magnetresonanzvorrichtung umfasst vorzugsweise eine HF-Sendespule zur Erzeugung eines Magnetresonanzanregungssignals, einen HF-Sender zur Erzeugung eines Nutzanregungssignals und eine Auswerteeinheit zur Ermittlung einer Auswertungsinformation.

Die Vorteile der Magnetresonanzvorrichtung entsprechen im Wesentlichen den Vorteilen der beschriebenen Ausführungsformen des vorgeschlagenen Verfahrens zur Ermittlung einer Auswertungsinformation aus einem durch die Magnetresonanzvorrichtung empfangenen Empfangssignal, welche vorab im Detail ausgeführt sind. Hierbei erwähnte Merkmale, Vorteile oder alternative Ausführungsformen können auch auf die anderen beanspruchten Gegenstände übertragen werden und umgekehrt.

Ferner wird ein Computerprogrammprodukt gemäß Anspruch 11 vorgeschlagen, das ein Programm umfasst und direkt in einen Speicher einer programmierbaren Systemsteuereinheit einer Magnetresonanzvorrichtung ladbar ist und Programmmittel, z.B. Bibliotheken und Hilfsfunktionen, aufweist, um ein vorab beschriebenes Verfahren auszuführen, wenn das Computerprogrammprodukt in der Systemsteuereinheit der Magnetresonanzvorrichtung ausgeführt wird. Das Computerprogrammprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Systemsteuereinheit zu laden ist. Durch das Computerprogrammprodukt kann das Verfahren schnell, identisch wiederholbar und robust ausgeführt werden. Das Computerprogrammprodukt ist so konfiguriert, dass es mittels der Systemsteuereinheit die Verfahrensschritte ausführen kann. Die Systemsteuereinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem computerlesbaren Medium gespeichert oder auf einem Netzwerk oder Server hinterlegt, von wo es in den Prozessor einer lokalen Systemsteuereinheit geladen werden kann, der mit der Magnetresonanzvorrichtung direkt verbunden oder als Teil der Magnetresonanzvorrichtung ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Systemsteuereinheit einer Magnetresonanzvorrichtung ein vorab beschriebenes Verfahren durchführen. Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Systemsteuereinheit der Magnetresonanzvorrichtung gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1 eine Magnetresonanzvorrichtung in einer schematischen Darstellung,

Fig. 2 ein Verfahren als Blockdiagramm,

Fig. 3 ein Frequenzdiagramm mit den Frequenzbändern eines Magnetresonanzsignals und eines Nutzsignals,

Fig. 4 ein erweitertes Verfahren als Blockdiagramm,

Fig. 5 eine schematische Darstellung eines Signalverarbeitung.

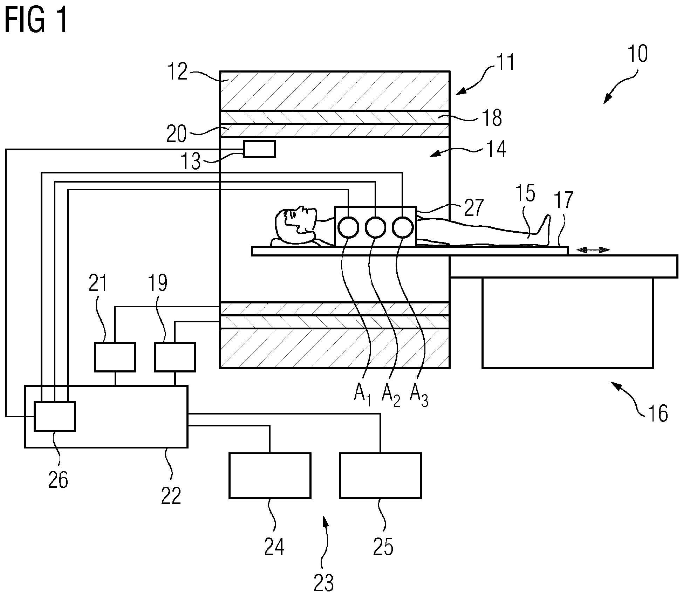

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Magnetresonanzvorrichtung 10 umfasst weiterhin eine HF-Sendespule 20, welche im vorliegenden Ausführungsbeispiel als fest in die Magnetresonanzvorrichtung 10 integrierte Körperspule ausgebildet ist. Die HF-Sendespule 20 ist zu einer Anregung von Atomkernen, die sich in dem von dem Hauptmagneten 12 erzeugten Hauptmagnetfeld 13 einstellt, ausgelegt. Die Hochfrequenzantenneneinheit 20 wird von einer HF-Steuereinheit 21 der Magnetresonanzvorrichtung 10 gesteuert und strahlt hochfrequente Magnetresonanzsequenzen in einen Untersuchungsraum ein, der im Wesentlichen von einem Patientenaufnahmebereich 14 der Magnetresonanzvorrichtung 10 gebildet ist. Die HF-Sendespule 20 ist weiterhin zum Empfang von Magnetresonanzsignalen ausgebildet.

Zu einer Steuerung des Hauptmagneten 12, der Gradientensteuereinheit 19 und zur Steuerung der HF-Steuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten bildgebenden Gradientenechosequenz. Zudem umfasst die Systemsteuereinheit 22 eine nicht näher dargestellte Bildberechnungseinheit zu einer Berechnung von Magnetresonanzabbildungen aus Magnetresonanzsignalen, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie berechnete Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Zudem weist die Magnetresonanzeinheit eine Lokalspule 27 auf, die am Patienten 15 angeordnet ist. In diesem Beispiel wird aus Gründen der übersichtlicheren Darstellbarkeit die Lokalspule 27 mit nur drei Spulenelementen $A_1$, $A_2$, $A_3$ gezeigt. Die Anzahl der Spulenelemente können jedoch auch größer oder kleiner sein. Jedes dieser Spulenelemente $A_1$, $A_2$, $A_3$ ist zum Empfang von HF-Signalen innerhalb des Frequenzbandes von Magnetresonanzsignalen ausgebildet.

Die Spulenelemente $A_1$, $A_2$, $A_3$ sind jeweils Teil eines Empfangskanals, d.h. hier sind 3 Empfangskanäle dargestellt. Über die Empfangskanäle werden die von den Spulenelemente $A_1$, $A_2$, $A_3$ empfangenen Signale an eine Auswerteeinheit 26 übertragen.

Ferner umfasst die Magnetresonanzvorrichtung einen HF-Sender 13, der ausgebildet ist ein Nutzanregungssignal zu emittieren. Das Nutzanregungssignal tritt erfindungsgemäß in Wechselwirkung mit einem Untersuchungsobjekt, nämlich dem Patienten 15.

Durch die Wechselwirkung verändert sich das Nutzanregungssignal in ein Nutzsignal.

Die Frequenzanteile des Nutzsignals liegen zumindest teilweise innerhalb des Frequenzbandes der Magnetresonanzsignale und können somit auch von den Spulenelementen $A_1$, $A_2$, $A_3$ der Lokalspule 27 empfangen werden.

Es ist denkbar, dass die Magnetresonanzvorrichtung 10, insbesondere der HF-Sender 13, einen hier nicht dargestellten Koppler aufweist, der ausgebildet ist, einen Anteil des Nutzanregungssignal der Auswerteeinheit 26 zuzuführen.

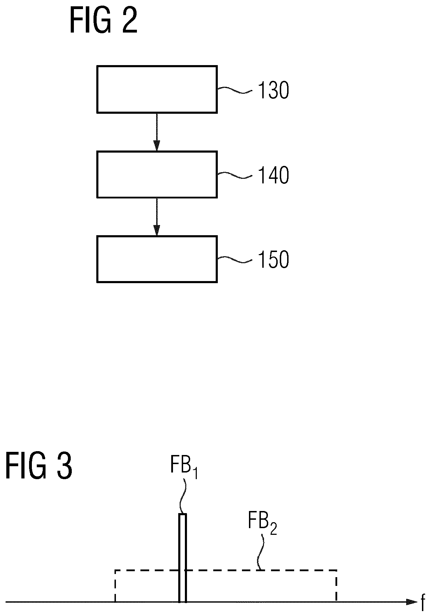

In Fig. 2 ist ein Verfahren zur Ermittlung einer Auswertungsinformation aus einem durch die Magnetresonanzvorrichtung 10 empfangenen Empfangssignal dargestellt, das einen Teil der Verfahrensschritte des erfindungsgemäßen Verfahrens nach Anspruch 1 beinhaltet. Dabei ist die Magnetresonanzvorrichtung 10 ausgebildet, in einem zweiten Frequenzband ein Magnetresonanzsignal zu erzeugen. In 130 wird ein Nutzsignal in einem ersten Frequenzband erzeugt, wobei das erste Frequenzband zumindest teilweise, insbesondere vollständig, innerhalb des zweiten Frequenzbands liegt. In 140 wird das Empfangssignal durch eine Empfangseinheit der Magnetresonanzvorrichtung 10 empfangen.

Die Empfangseinheit kann beispielsweise Spulenelemente $A_1$, $A_2$, $A_3$ umfassen. In 150 wird eine das Nutzsignal charakterisierende Auswertungsinformation aus dem Empfangssignal ermittelt.

In Fig. 3 sind beispielhaft ein erstes Frequenzband $FB_1$ des Nutzsignals und ein zweites Frequenzband $FB_2$ des Magnetresonanzsignals dargestellt. Auf der horizontalen Achse des Diagramms ist die Frequenz f aufgetragen. Hierbei befindet sich das erste Frequenzband $FB_1$ vollständig innerhalb des zweiten Frequenzbands $FB_2$. Somit ist die Empfangseinheit, die selbstverständlich ausgebildet ist, das zweite Frequenzband $FB_2$ abzudecken, um Magnetresonanzsignale empfangen zu können, auch in der Lage, Signale im ersten Frequenzband zu empfangen.

Dadurch können Nutzsignale auf dem zweiten Frequenzband $FB_2$, dem Magnetresonanz-Frequenzband, "mitgeschickt" werden. Eine zusätzliche, gesonderte Empfangseinheit ist also nicht nötig.

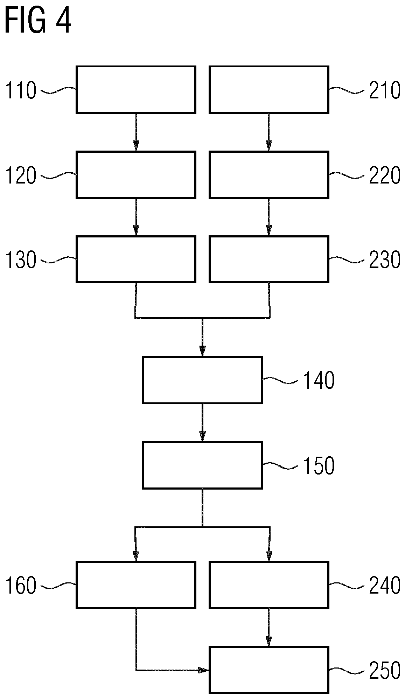

In Fig. 4 ist ein erweitertes Verfahren zur Ermittlung einer Auswertungsinformation aus einem durch die Magnetresonanzvorrichtung 10 empfangenen Empfangssignal dargestellt. Hierbei wird in 110 ein Nutzanregungssignal erzeugt. Durch Wechselwirkung mit einem Untersuchungsobjekt in Form eines Patienten 15 in 120 wird das Nutzanregungssignals in das Nutzsignal geändert, so dass in 130 das Nutzsignal 130 erzeugt wird. Es schließen sich die bereits in Fig. 2 dargestellten Schritte 140 und 150 an. In 160 werden die in 150 ermittelten Auswertungsinformation weiterverarbeitet. Ist beispielsweise in einer nicht erfindungsgemäßen Variante in 120 eine Wechselwirkung mit einer Empfangskette erfolgt, könnte in 160 eine Eigenschaft der Empfangskette ermittelt werden. Dies kann beispielsweise bei einer Überwachung einer Empfangseinheit zu Servicezwecken und/oder zur Eingrenzung einer Fehlerursache in der Empfangskette von Vorteil sein.

Das Verfahren weist erfindungsgemäß weitere Schritte auf. So wird in 210 ein Magnetresonanzanregungssignal erzeugt, dessen Frequenzanteile im zweiten Frequenzband $FB_2$ liegen. Durch eine Wechselwirkung mit dem Patienten 15 in 220 werden in 230 Magnetresonanzsignale erzeugt. Das in 130 erzeugte Nutzsignal und das in 230 erzeugte Magnetresonanzsignal überlagern sich zu einem Empfangssignal und werden in 140 empfangen.

In 150 wird eine das Nutzsignal charakterisierenden Auswertungsinformation aus dem Empfangssignal ermittelt. Damit einhergehend wird in 240 das Magnetresonanzsignal rekonstruiert. Aus dem Magnetresonanzsignal werden schließlich in 250 eine oder mehrere Magnetresonanzabbildungen berechnet. In diese Berechnung können auch Auswertungsinformationen aus 160 eingehen. Ist beispielsweise erfindungsgemäß

in 120 eine Wechselwirkung mit einem Patienten 15 erfolgt, wird erfindungsgemäß in 160 eine Bewegung des Patienten ermittelt. Diese Information kann im Rahmen einer Bewegungskorrektur bei der Berechnung der Magnetresonanzabbildungen in 250 berücksichtigt werden.

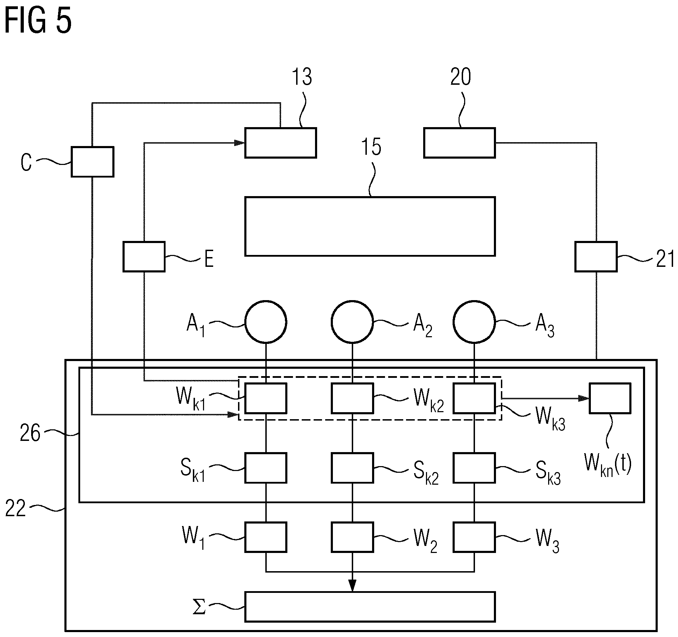

Mögliche Aspekte des vorgeschlagenen Verfahrens sollen anhand von Fig. 5 in Verbindung mit Fig. 4 und Fig. 3 detailliert beschrieben werden.

Ein, insbesondere digitales, Steuersignal E wird an den HF-Sender 13 geschickt, woraufhin der HF-Sender 13 in 110 ein Nutzanregungssignal innerhalb der Bandbreite des Magnetresonanzexperiments $FB_2$ emittiert. Das Nutzanregungssignal wird in 120 durch Wechselwirkung mit dem Patienten 15 in 130 in ein Nutzsignal überführt. Oftmals unterscheiden sich Nutzanregungssignal und das daraus entstehende Nutzsignal in ihrem Frequenzspektrum nicht wesentlich, so dass auch das Nutzanregungssignal im ersten Frequenzband $FB_1$ liegt.

In 140 wird das Nutzsignal von den Spulenelementen $A_1$, $A_2$, $A_3$ und den dahinter liegenden Empfangskomponenten, die mit dem jeweiligen Spulenelement jeweils einen Empfangskanal bilden, aufgenommen.

Im erfindungsgemäßen Falle, dass gleichzeitig Magnetresonanzsignale aufgenommen werden, emittiert in 210 die HF-Sendespule 20 gesteuert von der HF-Steuereinheit Magnetresonanzanregungssignale, die in 220 mit dem Patienten in Wechselwirkung treten, so dass in 230 Magnetresonanzsignale erzeugt werden. Die Magnetresonanzsignale werden dann überlagert mit dem Nutzsignal als Empfangssignal von den Spulenelementen $A_1$, $A_2$, $A_3$ in 140 empfangen. Dabei empfängt jedes Spulenelement $A_1$ $A_2$, $A_3$ jeweils einen Empfangssignalanteil des Empfangssignals.

Das Nutzanregungssignal ist in Amplitude und Phase vorzugsweise sehr genau bekannt. Dies ist beispielsweise dadurch gegeben, dass das Steuersignal E exakt bekannt ist und der HF-Sender 13 sehr genau kalibriert ist. Eine weitere Möglichkeit besteht darin, dass ein hier nicht dargestellter Koppler einen kleinen Teil C des Nutzanregungssignals auskoppelt und der Auswerteinheit 26 zuführt. In der Folge kann zur Ermittlung die Gewichtungsfaktoren $w_{kn}$ das Nutzanregungssignal verwendet werden.

Eine nachfolgende Signalverarbeitung in 150 subtrahiert das Nutzsignal von jedem einzelnen Empfangskanal. Vor der Subtraktion werden die Gewichtungsfaktoren $w_{kn}$ (n = 1, 2 oder 3) bestimmt, denen das Nutzsignal von dem jeweiligen Empfangssignalanteil abgezogen wird. Die Gewichtungsfaktoren $w_{kn}$ werden dabei so bestimmt, dass das Nutzsignal in korrigierten Empfangssignalanteilen $S_{kn}$ (n = 1, 2 oder 3) nach der Subtraktion minimiert wird. Eine Eliminierung solcher "Störsignale" durch entsprechende Subtraktion kann beispielsweise mit einem Sidelobe-Canceler-Verfahren durchgeführt werden.

Störunterdrückungen von über 60dB können hierbei erreicht werden. Im erfindungsgemäßen

Falle eines gleichzeitigen Empfangs von Magnetresonanzsignalen wird somit anhand der Gewichtungsfaktoren $w_{kn}$ aus dem Empfangssignal das Magnetresonanzsignal rekonstruiert.

Die korrigierten Empfangssignalanteilen $S_{kn}$ können in 240 in bekannter Weise gewichtet mit Spulenempfindlichkeiten $w_n$ (n = 1, 2 oder 3) zu einem Bilddatensatz $\Sigma$ kombiniert werden. Daraus können in 250 eine oder mehrere Magnetresonanzabbildungen berechnet werden.

Anstatt die Pegel (Amplitude und Phase) des Nutzsignals selbst auszuwerten, können in 160 insbesondere die Gewichtungsfaktoren $w_{kn}$ als Auswertungsinformation benutzt werden. Die Gewichtungsfaktoren $w_{kn}$ können insbesondere verwendet werden, um erfindungsgemäß eine Bewegung des Patienten 15 ermitteln. Dazu kann beispielsweise der zeitliche Verlauf $w_{kn}(t)$ bestimmt werden. Ferner können die Gewichtungsfaktoren $w_{kn}$ mit vorher bekannten Werten oder mit Werten benachbarter Spulenelemente verglichen werden. Zum Beispiel kann sich eine veränderte Kopplung zwischen Nutzsignal und Spulenelement auf Grund der Patientenbewegung entsprechend auf den Gewichtungsfaktor auswirken und diese komplexwertige Zahl kann direkt genutzt werden, um Patientenbewegung zu beobachten.

Es wird abschließend noch einmal darauf hingewiesen, dass es sich bei den vorhergehend detailliert beschriebenen Verfahren sowie bei der dargestellten Magnetresonanzvorrichtung lediglich um Ausführungsbeispiele handelt, welche vom Fachmann in verschiedenster Weise modifiziert werden können, ohne den Bereich der Erfindung zu verlassen, der durch die Ansprüche definiert wird. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

**Patentansprüche**

1. Verfahren zur Ermittlung einer Auswertungsinformation aus einem durch eine Magnetresonanzvorrichtung (10) empfangenen Empfangssignal umfassend:

    - Erzeugen eines Nutzsignals in einem ersten Frequenzband ($FB_1$) (130),
    - Erzeugen eines Magnetresonanzanregungssignals, dessen Frequenzanteile in einem zweiten Frequenzband ($FB_2$) liegen, wodurch im zweiten Frequenzband durch Wechselwirkung mit einem Patienten (15) ein Magnetresonanzsignal erzeugt wird, wobei das erste Frequenzband ($FB_1$) zumindest teilweise, insbesondere vollständig, innerhalb des zweiten Frequenzbands ($FB_2$) liegt, so dass sich das Nutzsignal und das Magnetresonanzsignal zu dem Empfangssignal überlagern,

- Empfangen des Empfangssignals durch eine Empfangseinheit der Magnetresonanzvorrichtung (10) (140),
- Ermittlung einer das Nutzsignal charakterisierenden Auswertungsinformation aus dem Empfangssignal (150),

wobei das Erzeugen des Nutzsignals umfasst:

- Erzeugen eines Nutzanregungssignals (110),
- Änderung des Nutzanregungssignals in das Nutzsignal durch Wechselwirkung mit dem Patienten (15) (120),

wobei anhand der Auswertungsinformation eine Bewegung des Patienten (15) ermittelt wird (160).

2. Verfahren nach Anspruch 1, wobei anhand der Auswertungsinformation aus dem Empfangssignal das Magnetresonanzsignal rekonstruiert wird (240).

3. Verfahren nach Anspruch 2, wobei zumindest aus dem rekonstruierten Magnetresonanzsignal zumindest eine Magnetresonanzabbildung berechnet wird (250).

4. Verfahren nach einem der vorangehenden Ansprüche, wobei zur Ermittlung der Auswertungsinformation das Nutzanregungssignal verwendet wird.

5. Verfahren nach Anspruch 4,

wobei ein Anteil des Nutzanregungssignal durch einen Koppler ausgekoppelt wird.

6. Verfahren nach einem der vorangehenden Ansprüche,

wobei die Empfangseinheit mehrere Empfangskanäle umfasst,
wobei für jeden Empfangskanal ein Gewichtungsfaktor als Auswertungsinformation ermittelt wird.

7. Verfahren nach den Ansprüchen 2 und 6, wobei die Gewichtungsfaktoren durch Rekonstruktion des Magnetresonanzsignals aus dem Empfangssignal ermittelt werden.

8. Verfahren nach Anspruch 6 oder 7,

wobei das Empfangssignal mehrere Empfangssignalanteile umfasst, die jeweils durch einen Empfangskanal empfangen werden,
wobei zur Rekonstruktion des Magnetresonanzsignals für jeden Empfangskanal das Nutzanregungssignal vom jeweiligen Empfangssignalanteil mit dem jeweils ermittelten Gewichtungsfaktor gewichtet subtrahiert wird.

9. Verfahren nach einem der Ansprüche 7 bis 8, wobei eine zeitliche Änderung des zumindest einen Gewichtungsfaktor ermittelt wird und/oder ein Vergleich des zumindest einen Gewichtungsfaktors mit zumindest einem vorgegebenen Referenzwert durchgeführt wird und/oder ein Vergleich des zumindest einen Gewichtungsfaktors eines Empfangskanals mit zumindest einem Gewichtungsfaktors eines anderen Empfangskanals durchgeführt wird.

10. Magnetresonanzvorrichtung (10) ausgebildet ein Verfahren nach einem der Ansprüche 1 bis 9 auszuführen.

11. Computerprogrammprodukt, welches ein Programm umfasst und direkt in einen Speicher einer programmierbaren Systemsteuereinheit einer Magnetresonanzvorrichtung (10) ladbar ist, mit Programmmitteln, um ein Verfahren nach einem der Ansprüche 1 bis 9 auszuführen, wenn das Programm in der Systemsteuereinheit (22) der Magnetresonanzvorrichtung (10) ausgeführt wird.

**Claims**

1. Method for determining an item of evaluation information from a reception signal received by a magnetic resonance apparatus (10), comprising:

- generating a useful signal in a first frequency band ($FB_1$) (130),
- generating a magnetic resonance excitation signal, the frequency portions of which lie within a second frequency band ($FB_2$), causing a magnetic resonance signal to be generated in the second frequency band by interaction with a patient (15), wherein the first frequency band ($FB_1$) lies at least partially, in particular completely, within the second frequency band ($FB_2$), so that the useful signal and the magnetic resonance signal are overlaid to form the reception signal,
- receiving the reception signal by a receiving unit of the magnetic resonance apparatus (10) (140),
- determining an item of evaluation information characterising the useful signal from the reception signal (150),

wherein the generation of the useful signal comprises:

- generating a useful excitation signal (110),
- changing the useful excitation signal into the useful signal by interaction with the patient (15) (120),

wherein, on the basis of the evaluation information, a movement of the patient (15) is determined (160).

2. Method according to claim 1,
wherein, on the basis of the evaluation information, the magnetic resonance signal is reconstructed (240) from the reception signal.

3. Method according to claim 2,
wherein at least one magnetic resonance image is calculated at least from the reconstructed magnetic resonance signal.

4. Method according to one of the preceding claims,
wherein the useful excitation signal is used for determining the evaluation information.

5. Method according to claim 4,
wherein a portion of the useful excitation signal is decoupled by a coupler.

6. Method according to one of the preceding claims,

   wherein the receiving unit comprises a plurality of receiving channels,
   wherein for each receiving channel, a weighting factor is determined as evaluation information.

7. Method according to claims 2 and 6,
wherein the weighting factors are determined by reconstruction of the magnetic resonance signal from the reception signal.

8. Method according to claim 6 or 7,

   wherein the reception signal comprises a plurality of reception signal portions which are each received by a receiving channel,
   wherein for the reconstruction of the magnetic resonance signal for each receiving channel, the useful excitation signal is subtracted from the respective reception signal portion weighted with the respectively determined weighting factor.

9. Method according to one of claims 7 to 8,
wherein a temporal change in the at least one weighting factor is determined and/or a comparison of the at least one weighting factor with at least one predetermined reference value is carried out and/or a comparison of the at least one weighting factor of a receiving channel with at least one weighting factor of another receiving channel is carried out.

10. Magnetic resonance apparatus (10) configured to carry out a method according to one of claims 1 to 9.

11. Computer program product which comprises a program and is directly loadable into a memory store of a programmable system control unit of a magnetic resonance apparatus (10), comprising program means in order to carry out a method according to one of the claims 1 to 9 when the program is executed in the system control unit (22) of the magnetic resonance apparatus (10).

**Revendications**

1. Procédé de détermination d'une information d'évaluation à partir d'un signal de réception reçu par un dispositif (10) de résonance magnétique, comprenant :

   - production d'un signal utile dans une première bande de fréquences ($FB_1$) (130),
   - production d'un signal d'excitation de résonance magnétique, dont la composante de fréquence se trouve dans une deuxième bande ($FB_2$) de fréquence, grâce à quoi on produit un signal de résonance magnétique dans la deuxième bande de fréquence par interaction avec un patient (15),
   dans lequel la première bande ($FB_1$) de fréquence est au moins en partie, en particulier entièrement, dans la deuxième bande ($FB_2$) de fréquence, de manière à ce que le signal utile et le signal de résonance magnétique se superposent au signal de réception,

   - réception du signal de réception par une unité de réception du dispositif (10) de résonance magnétique (140),
   - détermination d'une information d'évaluation caractérisant le signal utile à partir du signal (150) de réception,

   dans lequel la production du signal utile comprend :

   - production d'un signal (110) d'excitation utile,
   - modification du signal d'excitation utile dans le signal utile par interaction avec le patient (15) (120),

   dans lequel on détermine un mouvement du patient (15) à l'aide de l'information d'évaluation (160).

2. Procédé suivant la revendication 1,
dans lequel, à l'aide de l'information d'évaluation, on reconstruit le signal de résonance magnétique à partir du signal de réception (240).

3. Procédé suivant la revendication 2,

dans lequel on calcule au moins une représentation du signal de résonance magnétique au moins à partir du signal de résonance magnétique reconstruit (250).

**4.** Procédé suivant l'une des revendications précédentes,
dans lequel on utilise le signal d'excitation utile pour la détermination de l'information d'évaluation.

**5.** Procédé suivant la revendication 4,
dans lequel on découple une composante du signal d'excitation utile par un coupleur.

**6.** Procédé suivant l'une des revendications précédentes,
dans lequel l'unité de réception comprend plusieurs canaux de réception, dans lequel on détermine, comme information d'évaluation pour chaque canal de réception, un facteur de pondération.

**7.** Procédé suivant les revendications 2 et 6,
dans lequel on détermine les facteurs de pondération par reconstruction du signal de résonance magnétique, à partir du signal de réception.

**8.** Procédé suivant la revendication 6 ou 7,

dans lequel le signal de réception comprend plusieurs composantes de signal de réception, que l'on reçoit respectivement par un canal de réception,
dans lequel, pour la reconstruction du signal de résonance magnétique, on soustrait, d'une manière pondérée par le facteur de pondération déterminé respectivement pour chaque canal de réception, le signal d'excitation utile de la composante respective de signal de réception.

**9.** Procédé suivant l'une des revendications 7 à 8,
dans lequel on détermine une variation en fonction du temps du au moins un facteur de pondération et/ou on effectue une comparaison du au moins un facteur de pondération à au moins une valeur de référence donnée à l'avance et/ou on effectue une comparaison du au moins un facteur de pondération d'un canal de réception à au moins un facteur de pondération d'un autre canal de réception.

**10.** Dispositif (10) de résonance magnétique constitué pour exécuter un procédé suivant l'une des revendications 1 à 9.

**11.** Produit de programme d'ordinateur, qui comprend un programme et qui peut être chargé directement dans la mémoire d'une unité de commande de système programmable d'un dispositif (10) de résonance magnétique, comprenant des moyens de programme pour exécuter un procédé suivant l'une des revendications 1 à 9, lorsque l'on exécute le programme dans l'unité (22) de commande de système du dispositif (10) de résonance magnétique.

FIG 1

FIG 2

FIG 3

# FIG 4

110 — [ ]  [ ] — 210

120 — [ ]  [ ] — 220

130 — [ ]  [ ] — 230

[ ] — 140

[ ] — 150

160 — [ ]  [ ] — 240

[ ] — 250

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006244452 A1
- US 2018045801 A1
- US 2013342199 A1